(19) Europäisches Patentamt
European Patent Office
Office européen des brevets

(11) **EP 1 293 785 B1**

(12) **EUROPÄISCHE PATENTSCHRIFT**

(45) Veröffentlichungstag und Bekanntmachung des Hinweises auf die Patenterteilung:
**28.07.2004 Patentblatt 2004/31**

(51) Int Cl.$^7$: **G01R 19/165**

(21) Anmeldenummer: **02018984.1**

(22) Anmeldetag: **27.08.2002**

(54) **Spannungskomparator**

Voltage comparator

Comparateur de tension

(84) Benannte Vertragsstaaten:
**DE FR IT**

(30) Priorität: **14.09.2001 DE 10145562**

(43) Veröffentlichungstag der Anmeldung:
**19.03.2003 Patentblatt 2003/12**

(73) Patentinhaber: **Infineon Technologies AG**
**81669 München (DE)**

(72) Erfinder: **Horn, Wolfgang**
**9500 Villach (AT)**

(74) Vertreter: **Repkow, Ines, Dr. Dipl.-Ing. et al**
**Jannig & Repkow**
**Patentanwälte**
**Klausenberg 20**
**86199 Augsburg (DE)**

(56) Entgegenhaltungen:
**US-A- 6 133 764**

- **PATENT ABSTRACTS OF JAPAN vol. 013, no. 520 (P-963), 21. November 1989 (1989-11-21) -& JP 01 212364 A (MATSUSHITA ELECTRIC IND CO LTD), 25. August 1989 (1989-08-25)**
- **PATENT ABSTRACTS OF JAPAN vol. 1996, no. 10, 31. Oktober 1996 (1996-10-31) -& JP 08 152445 A (NIPPON TELEGR &AMP;TELEPH CORP &LT;NTT&GT;), 11. Juni 1996 (1996-06-11)**

EP 1 293 785 B1

**Beschreibung**

Die vorliegende Erfindung betrifft eine Vorrichtung gemäß dem Oberbegriff des Patentanspruchs 1, d.h. einen Komparator, welcher ein vom Größenverhältnis einer ersten Spannung und einer zweiten Spannung abhängendes Ausgangssignal erzeugt.

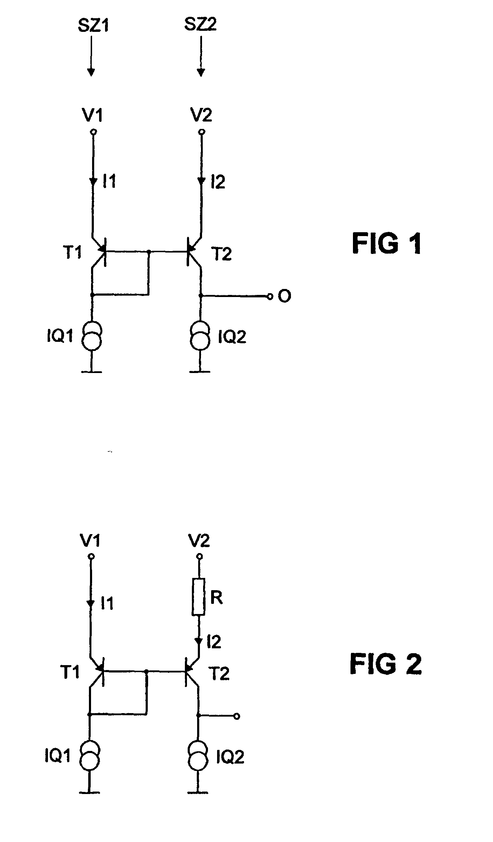

Ein solcher Komparator ist in Figur 1 dargestellt.

Der in der Figur 1 gezeigte Komparator besteht aus zwei miteinander verbundenen Schaltungszweigen, wobei

- der in der Figur 1 mit dem Bezugszeichen SZ1 bezeichnete erste Schaltungszweig einen ersten pnp-Transistor T1 und eine erste Stromquelle IQ1 enthält, wobei

  - der Emitter des Transistors T1 mit einer ersten Spannung V1, welches eine der miteinander zu vergleichenden Spannungen ist, beaufschlagt ist, und
  - die Basis und der Kollektor des Transistors T1 über die Stromquelle IQ1 mit Masse verbunden sind,

- der in der Figur 1 mit dem Bezugszeichen SZ2 bezeichnete zweite Schaltungszweig einen ersten pnp-Transistor T2 und eine erste Stromquelle IQ2 enthält, wobei

  - der Emitter des Transistors T2 mit einer zweiten Spannung V2, welches die andere der miteinander zu vergleichenden Spannungen ist, beaufschlagt ist, und
  - und der Kollektor des Transistors T2

    - über die Stromquelle IQ2 mit Masse verbunden ist, und
    - mit einem Ausgangsanschluß O verbunden ist, über welchen ein das Ergebnis des Vergleichs der Spannungen V1 und V2 repräsentierendes Signal ausgegeben wird, und

- die Basis des ersten Transistors T1 und die Basis des zweiten Transistors T2 miteinander verbunden sind.

Durch den ersten Schaltungszweig SZ1 fließt ein durch die Stromquelle IQ1 bestimmter Strom I1 wobei sich am Basisanschluß des Transistors T1 ein von der Größe der Spannung V1 abhängendes Potential einstellt. Durch den zweiten Schaltungszweig SZ2 fließt ein Strom I2, dessen Größe von der Differenz der Spannungen V1 und V2, genauer gesagt von der Spannung V2 und dem von der Spannung V1 abhängenden Basispotential des Transistors T2 abhängt, und von dessen Größe das am Ausgangsanschluß O abgreifbare Signal abhängt.

Solche Komparatoren sind bekannt, so daß auf die Beschreibung weiterer Einzelheiten verzichtet werden kann.

Üblicherweise sind die Transistoren T1 und T2 sowie die Stromquellen IQ1 und IQ2 gleich dimensioniert. Dadurch gilt im Gleichgewichtszustand (im Umschaltzeitpunkt) des Komparators, daß V1 = V2. Anderenfalls, genauer gesagt, wenn sich - bedingt durch eine andere Dimensionierung der Transistoren und/oder der Stromquellen - im Gleichgewichtszustand des Komparators an den Transistoren T1 und T2 unterschiedliche Basis-Emitter-Spannungen einstellen, würde im Gleichgewichtszustand des Komparators gelten, daß V1 = V2 ± Voff ist, wobei Voff die bekannte Offsetspannung ist.

Das Auftreten einer Offsetspannung ist im allgemeinen unerwünscht. Bisweilen, beispielsweise wenn der Komparator eine Hysterese aufweisen soll, oder wenn eine der zu vergleichenden Spannungen eine Referenzspannung sein soll, die aber in der den Komparator enthaltenden Anordnung nicht zur Verfügung steht, kann es sich als vorteilhaft erweisen, wenn eine Offsetspannung vorhanden ist, wobei eine solche Offsetspannung jedoch genau und dauerhaft auf einen bestimmten Wert einstellbar sein sollte, und vorzugsweise innerhalb eines größeren Bereiches variierbar sein sollte.

Die Generierung einer Offsetspannung wäre bei dem in der Figur 1 gezeigten Komparator beispielsweise dadurch möglich, daß die Transistoren T1 und T2 und/oder die Stromquellen IQ1 und IQ2 unterschiedlich dimensioniert werden. Die sich dadurch einstellende Offsetspannung Voff beträgt

$$\text{Voff} = \frac{kT}{q} \ln\left(\frac{I1}{I2}\right)$$

Nachteilig hieran ist, daß die Offsetspannung Voff stark temperaturabhängig ist, und sich zudem nur kleine Offsetspannungen (bis einige mV) realisieren lassen, weil anderenfalls das Verhältnis von I1 zu I2 zu extrem wird.

Eine auf diese Art und Weise generierte Offsetspannung ist nach alledem weder genau und dauerhaft einstellbar, noch innerhalb eines großen Bereiches variierbar.

Eine andere Möglichkeit zur Offsetspannungs-Generierung ist in Figur 2 dargestellt.

Die in der Figur 2 gezeigte Anordnung ist ein Komparator, der weitestgehend dem in der Figur 1 gezeigten Komparator entspricht. Mit den selben Bezugszeichen bezeichnete Elemente bezeichnen identische oder einander entsprechende Elemente.

Der in der Figur 2 gezeigte Komparator weist jedoch zusätzlich einen Widerstand R auf, der zwischen dem Emitter des zweiten Transistors T2 und dem Eingangsanschluß für die zweite Spannung V2 angeordnet ist.

Die durch diesen Komparator erzeugte Offsetspannung Voff beträgt

$$\text{Voff} = R \cdot I2 \qquad \text{(für I1 = I2), bzw.}$$

$$\mathbf{Voff \ = \ R \cdot I2 + \frac{kT}{q} \ ln\left(\frac{I1}{I2}\right)} \qquad \text{(für I1} \neq \text{I2)}$$

Nachteilig hieran ist, daß der Widerstand R den Strom begrenzt, durch welchen eine am Ausgangsanschluß O angeschlossene kapazitive Last umgeladen werden kann. Die Folge hiervon ist, daß das über den Ausgangsanschluß O ausgegebene Signal relativ langsam auf Veränderungen von V1 und/oder V2 reagiert, der Komparator also ein relativ langsames Schaltverhalten aufweist.

Der vorliegenden Erfindung liegt daher die Aufgabe zugrunde, einen Komparator zu schaffen, dessen Offsetspannung genau und dauerhaft auf einen innerhalb eines großen Bereiches variierbaren Wert einstellbar ist, und bei welchem die Offsetspannungseinstellung nicht zu einer Verschlechterung der sonstigen Eigenschaften des Komparators, insbesondere nicht zu einer verlangsamten Reaktion auf Veränderungen der Eingangsspannungen führt.

Diese Aufgabe wird erfindungsgemäß durch den in Patentanspruch 1 beanspruchten Komparator gelöst.

Der erfindungsgemäße Komparator enthält eine erste Steuereinrichtung, eine zweite Steuereinrichtung, einen Widerstand, eine erste Stromquelle und eine zweite Stromquelle,

- wobei die erste Steuereinrichtung einen ersten Anschluß, einen zweiten Anschluß, und einen dritten Anschluß aufweist,

  - wobei der erste Anschluß zur Eingabe der ersten Spannung dient,
  - wobei der zweite Anschluß mit dem dritten Anschluß verbunden ist, und über den Widerstand mit einem Anschluß der zweiten Steuereinrichtung verbunden ist, und
  - wobei der dritte Anschluß mit der ersten Stromquelle verbunden ist, und über den dritten Anschluß ein Strom fließt, dessen Größe von der Differenz der an den ersten Anschluß und an den zweiten Anschluß angelegten Spannungen abhängt, und

- wobei die zweite Steuereinrichtung einen ersten Anschluß, einen zweiten Anschluß, einen dritten Anschluß und einen vierten Anschluß aufweist,

  - wobei der erste Anschluß zur Eingabe der zweiten Spannung dient,
  - wobei der zweite Anschluß mit dem vierten Anschluß verbunden ist, und über den Widerstand mit dem zweiten Anschluß der ersten Steuereinrichtung verbunden ist,
  - wobei der dritte Anschluß mit der zweiten Stromquelle verbunden ist, und über den dritten Anschluß ein Strom fließt, dessen Größe von der Differenz der an den ersten Anschluß und an den zweiten Anschluß angelegten Spannungen abhängt, und am dritten Anschluß das Ausgangssignal des Komparators abgegriffen wird, und
  - wobei der vierte Anschluß mit dem zweiten Anschluß verbunden ist, und über den vierten Anschluß ein Strom fließt, dessen Größe von der Differenz der an den ersten Anschluß und an den zweiten Anschluß angelegten Spannungen abhängt.

Bei einem solchen Komparator fließt im Gleichgewichtszustand (im Umschaltzeitpunkt) des Komparators ein definierter Strom durch den Widerstand, wobei der dadurch am Widerstand hervorgerufene Spannungsabfall die Offsetspannung des Komparators oder eine der Spannungskomponenten ist, aus welchen sich die Offsetspannung zusammensetzt.

Vorzugsweise sind die Differenz zwischen den an den ersten Anschluß und an den zweiten Anschluß der ersten Steuereinrichtung angelegten Spannungen und die Differenz zwischen den an den ersten Anschluß und an den zweiten Anschluß der zweiten Steuereinrichtung angelegten Spannungen gleich groß. Dann ist die am Widerstand abfallende Spannung genau die Offsetspannung des Komparators.

Die Offsetspannung ist durch eine entsprechende Dimensionierung des Widerstandes und/oder der Stromquellen genau und dauerhaft auf beliebig große Werte einstellbar. Weil der die Offsetspannung generierende Widerstand nicht in dem Pfad liegt, über welchen der Ausgangsanschluß des Komparators mit Strom versorgt wird, hat die Offsetspannungs-Generierung keinen Einfluß auf die Geschwindigkeit, mit welcher sich das Ausgangssignal ändern kann.

Vorteilhafte Weiterbildungen der Erfindung sind den Unteransprüchen, der folgenden Beschreibung, und den Figuren entnehmbar.

Die Erfindung wird nachfolgend anhand eines Ausführungsbeispiels unter Bezugnahme auf die Figuren näher erläutert. Es zeigen

Figur 1    den Aufbau eines herkömmlichen Komparators,

Figur 2    den Aufbau eines Komparators mit einstellbarem Offset,

Figur 3    den prinzipiellen Aufbau des im folgenden näher beschriebenen Komparators, und

Figur 4    eine mögliche praktische Realisierung des in der Figur 3 gezeigten Komparators.

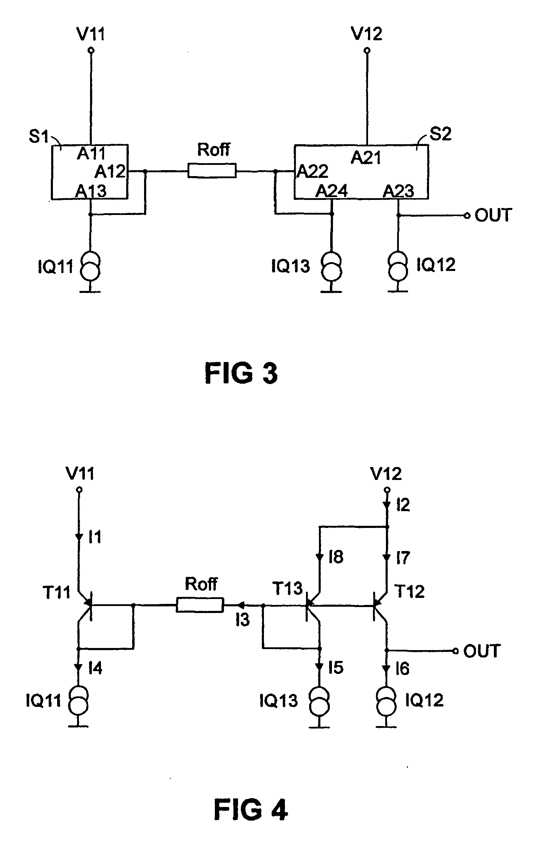

Gemäß dem in der Figur 3 gezeigten Prinzipschaltbild besteht der im folgenden näher beschriebene Komparator aus einer ersten Steuereinrichtung S1, einer zweiten Steuereinrichtung S2, einer ersten Stromquelle IQ11, einer zweiten Stromquelle IQ12, einer dritten Stromquelle IQ13, und einem Widerstand Roff, wobei die dritte Stromquelle IQ13 auch weggelassen werden könnte.

Der Komparator erhält eine erste Eingangsspannung V11 und eine zweite Eingangsspannung V12 und erzeugt ein vom Größenverhältnis dieser Spannungen abhängendes Ausgangssignal OUT.

Die erste Steuereinrichtung S1 weist drei Anschlüsse A11 bis A13 auf, von welchen

- der erste Anschluß A11 zur Eingabe der Spannung V11 dient,
- der zweite Anschluß A12

    - über den Widerstand Roff mit einem zweiten Anschluß A22 der zweiten Steuereinrichtung S2 verbunden ist, und
    - mit dem dritten Anschluß A13 verbunden ist, und

- der dritte Anschluß A13 über die erste Stromquelle IQ11 mit Masse verbunden ist.

Die zweite Steuereinrichtung S2 weist vier Anschlüsse A21 bis A24 auf, von welchen

- der erste Anschluß A21 zur Eingabe der Spannung V12 dient,
- der zweite Anschluß A12

    - über den Widerstand Roff mit dem zweiten Anschluß A12 der ersten Steuereinrichtung S1 verbunden ist, und
    - mit dem vierten Anschluß A24 verbunden ist,

- der dritte Anschluß A23 über die zweite Stromquelle IQ12 mit Masse verbunden ist, und
- der vierte Anschluß A24 über die dritte Stromquelle IQ13 mit Masse verbunden ist (sofern eine dritte Stromquelle IQ13 vorgesehen ist).

Die erste Steuereinrichtung S1 verhält sich so, daß über den dritten Anschluß A13 ein Strom fließt, dessen Größe von der Differenz zwischen der an den ersten Anschluß A11 angelegten Spannung V11 und der an den zweiten Anschluß A12 angelegten Spannung abhängt.

Die zweite Steuereinrichtung S2 verhält sich so, daß über den dritten Anschluß A23 und über den vierten Anschluß A24 Ströme fließen, deren Größe von der Differenz zwischen der an den ersten Anschluß A21 angelegten Spannung V12 und der an den zweiten Anschluß A22 angelegten Spannung abhängt.

Dadurch fließt im Gleichgewichtszustand (im Umschaltzeitpunkt) des Komparators ein definierter Strom durch den Widerstand Roff, wobei der dadurch am Widerstand hervorgerufene Spannungsabfall die Offsetspannung des Komparators oder eine der Spannungskomponenten ist, aus welchen sich die Offsetspannung zusammensetzt.

Vorzugsweise sind die Differenz zwischen den an den ersten Anschluß A11 und an den zweiten Anschluß A12 der ersten Steuereinrichtung S1 angelegten Spannungen und die Differenz zwischen den an den ersten Anschluß A21 und an den zweiten Anschluß A22 der zweiten Steuereinrichtung S2 angelegten Spannungen gleich groß. Dann ist die am Widerstand Roff abfallende Spannung genau die Offsetspannung des Komparators.

Die Offsetspannung ist durch eine entsprechende Dimensionierung des Widerstandes Roff und/oder der Stromquellen IQ11 bis IQ13 genau und dauerhaft auf beliebig große Werte einstellbar. Darüber hinaus liegt der die Offsetspannung generierende Widerstand nicht in dem Pfad, über welchen der Ausgangsanschluß OUT des Komparators mit Strom versorgt wird, so daß die Offsetspannungs-Generierung keinen Einfluß auf die Geschwindigkeit hat, mit welcher sich das Ausgangssignal ändern kann.

Eine mögliche praktische Ausführung der in der Figur 3 gezeigten Schaltung ist in der Figur 4 dargestellt.

Bei der in der Figur 4 gezeigten Schaltung wird die erste Steuereinrichtung S1 durch einen ersten pnp-Transistor T11 gebildet, wobei der Emitteranschluß des Transistors T11 dem ersten Anschluß A11 der ersten Steuereinrichtung S1 entspricht, der Basisanschluß des Transistors T11 dem zweiten Anschluß A12 der ersten Steuereinrichtung S1 entspricht, und der Kollektoranschluß des Transistors T11 dem dritten Anschluß A13 der ersten Steuereinrichtung S1 entspricht.

Die zweite Steuereinrichtung S2 wird durch einen zweiten pnp-Transistor T12 und einen dritten pnp-Transistor T13 gebildet, wobei die (miteinander verbunden) Emitteranschlüsse der Transistoren T12 und T13 dem ersten Anschluß A21 der zweiten Steuereinrichtung S2 entsprechen, die (miteinander verbundenen) Basisanschlüsse der Transistoren T12 und T13 dem zweiten Anschluß A22 der zweiten Steuereinrichtung S2 entsprechen, der Kollektoranschluß des ersten Transistors T12 dem dritten Anschluß A23 der zweiten Steuereinrichtung S2 entspricht, und der Kollektoranschluß des zweiten Transistors T13 dem vierten Anschluß A24 der zweiten Steuereinrichtung S2 entspricht.

Vorzugsweise werden die Komponenten des Komparators, genauer gesagt die Transistoren T11 bis T13 und die Stromquelle IQ11 bis IQ13 so dimensioniert, daß die absichtlich erzeugte Offsetspannung des Komparators die am Widerstand Roff abfallende Spannung ist und keine weiteren Komponenten enthält. Um dies zu erreichen, müssen im Gleichgewichtszustand (im Umschaltzeitpunkt) des Komparators die Basis-Emitter-Spannungen der Transistoren T11 bis T13 gleich sein. Dies läßt sich am einfachsten dadurch erreichen, daß die Transistoren T11 bis T13 durch identische Transistoren realisiert werden, und daß durch eine entsprechende Dimensionierung der Stromquellen dafür gesorgt wird, daß die die Transistoren T11 bis T13 durchfließenden Ströme gleich sind, wobei letzteres dadurch erreicht werden kann, daß dann, wenn keine dritte Stromquelle IQ13 vorgesehen ist, der von der ersten Stromquelle IQ11 gelieferte Strom doppelt so groß ist wie der von der zweiten Stromquelle IQ12 gelieferte Strom, bzw. daß dann, wenn die dritte Stromquelle IQ13 vorgesehen ist, der von der ersten Stromquelle IQ11 gelieferte Strom um den von der dritten Stromquelle IQ13 gelieferten Strom kleiner ist als das Doppelte des von der zweiten Stromquelle IQ12 gelieferten Stroms.

Der Vollständigkeit halber sei darauf hingewiesen, daß keine zwingende Notwendigkeit besteht, die Transistoren T11 bis T13 und die Stromquellen IQ11 bis IQ13 wie erwähnt zu dimensionieren. Dann entspricht die erzeugte Offsetspannung allerdings nicht der am Widerstand Roff abfallenden Spannung, sondern enthält, wie es bei der Offsetspannung des Komparators gemäß Figur 2 bei $I1 \neq I2$ der Fall ist, eine weitere, stark temperaturabhängige Komponente, was zwar im allgemeinen unerwünscht sein dürfte, aber unter Umständen nicht stört.

Die weiteren Ausführungen beziehen sich darauf, daß die Transistoren T11 bis T13 und die Stromquellen IQ11 bis IQ13 wie vorstehend erwähnt dimensioniert sind.

Im folgenden wird beschrieben, wie sich die am Widerstand Roff abfallende Offsetspannung auf einen gewünschten Wert einstellen läßt.

Die Erläuterung erfolgt anhand von innerhalb des Komparators fließenden Strömen I1 bis I8, von welchen

- der Strom I1 der den Transistor T11 durchfließende Strom ist,
- der Strom I2 die Summe der die Transistoren T12 und T13 durchfließenden Ströme ist,
- der Strom I3 der den Widerstand Roff durchfließende Strom ist,
- der Strom I4 der von der Stromquelle IQ11 abgegebene Strom ist,
- der Strom I5 der von der Stromquelle IQ13 abgegebene Strom ist,
- der Strom I6 der von der Stromquelle IQ12 abgegebene Strom ist,
- der Strom I7 der den Transistor T12 durchfließende Strom ist, und
- der Strom I8 der den Transistor T13 durchfließende Strom ist.

Die Basisströme der Transistoren werden vernachlässigt.

Wie insbesondere der Figur 4 und der darauf bezugnehmenden Beschreibung entnehmbar ist, ist die durch den vorstehend beschriebenen Komparator absichtlich erzeugte Offsetspannung die am Widerstand Roff abfallende Spannung Voff. Diese beträgt Voff = Roff · I3 und ist folglich durch eine entsprechende Dimensionierung des Widerstandes Roff und/oder des Stromes I3 einstellbar.

Wie auf den Strom I3 Einfluß genommen werden kann, hängt davon ab, ob die dritte Stromquelle IQ13 vorhanden ist oder nicht. Diese beiden Fälle werden daher im folgenden getrennt voneinander betrachtet.

In beiden Fällen wird davon ausgegangen, daß I1 = I7 = I8, was bei Erfüllung der vorstehend genannten Bedingungen, die erfüllt sein müssen, damit die zu erzeugende Offsetspannung genau die am Widerstand Roff abfallende Spannung ist, automatisch der Fall ist.

Des weiteren wird davon ausgegangen, daß der Ausgang OUT rein kapazitiv belastet ist, so daß gilt: I7 = I6

Wenn die dritte Stromquelle IQ13 nicht vorhanden ist, gilt I5=0, und I3 = I8, wobei wegen I1 = I7 = I8 und wegen I7 = I6, weiter gilt, daß I3 = I6. Die Offsetspannung Voff beträgt damit Voff = Roff · I6, und ist damit außer durch eine Veränderung von Roff auch über eine Veränderung von I6 einstellbar bzw. variierbar.

Wenn die dritte Stromquelle IQ13 vorhanden ist, gilt I5 ≠ 0, und I3 = I8 - I5, wobei wegen I1 = I7 = I8 und wegen I7 = I6, weiter gilt, daß I8 = I6. Die Offsetspannung Voff beträgt damit Voff = Roff · (I6 - I5), und ist damit außer durch eine Veränderung von Roff auch über eine Veränderung von I5 und/oder I6 einstellbar bzw. variierbar.

Durch den vorstehend beschriebenen Komparator läßt sich die Offsetspannung auf äußerst einfache Art und Weise genau und dauerhaft auf einen gewünschten Wert einstellen. Die eingestellte Offsetspannung ist nicht temperaturabhängig, innerhalb eines sehr großen Bereiches variierbar und durch entsprechenden Veränderungen der Größe des Widerstandes Roff und/oder der Größe der Ströme der Stromquellen, von deren Dimensionierung der über den Widerstand fließende Strom abhängt, auch während des Betriebes des Komparators veränderbar. Veränderungen der Größe des Widerstandes Roff und/oder der Größe der Ströme der Stromquellen, von deren Dimensionierung der über den Widerstand fließende Strom abhängt, können beispielsweise unter Verwendung von von außerhalb des Komparators steuerbaren Schaltern oder Steuerelementen erfolgen.

Die Offsetspannungs-Generierung beeinflußt auch nicht, jedenfalls nicht zwangsläufig die Schaltgeschwindigkeit des Komparators. Die Schaltgeschwindigkeit beim Umschalten des Ausgangssignals des Komparators vom niedrigen auf den hohen Pegel wird durch den Strom I2 bzw. I7 bestimmt, wobei der von diesem Strom durchflossene Schaltungszweig anders als etwa beim Komparator gemäß Figur 2 keinen den Stromfluß begrenzenden Widerstand oder sonstige Lasten enthält. Die Schaltgeschwindigkeit beim Umschalten des Ausgangssignals des Komparators vom hohen auf den niedrigen Pegel wird durch den Strom I6 bestimmt. Dieser kann, muß aber nicht verändert werden, um die Offsetspannung wunschgemäß einzustellen. Die Offsetspannung kann schließlich auch über den Widerstand Roff eingestellt oder verändert werden. Sofern die dritte Stromquelle IQ13 vorgesehen ist kann die Einstellung bzw. die Veränderung der Offsetspannung auch durch eine entsprechende Einstellung bzw. Veränderung des von der dritten Stromquelle abgegebenen Stromes I5 erfolgen. Das Vorsehen der dritten Stromquelle IQ13 ermöglicht es, die Offsetspannung in einem prinzipiell unbegrenzt großen Bereich zu variieren, ohne den von der zweiten Stromquelle IQ12 abgegebenen Strom I6 verändern zu müssen. Dadurch sind die Offsetspannung und die Schaltgeschwindigkeit des Komparators unabhängig voneinander und ohne gegenseitige Beeinflussung innerhalb sehr großer Bereiche einstellbar bzw. variierbar.

Es dürfte einleuchten und bedarf keiner näheren Erläuterung, daß die Transistoren T11 bis T13 nicht durch pnp-Transistoren realisiert werden müssen. Sie können - gegebenenfalls nach entsprechender Anpassung des Komparatoraufbaus - auch durch beliebige andere Transistoren, beispielsweise npn-Transistoren oder Feldeffekttransistoren realisiert werden.

Die Transistoren T12 und T13 können auch durch einen einzigen Transistor mit zwei Kollektoren gebildet werden.

Der vorstehend beschriebene Komparator ermöglicht es unabhängig von den Einzelheiten der praktischen Realisierung, daß dessen Offsetspannung genau und dauerhaft auf einen innerhalb eines großen Bereiches variierbaren Wert einstellbar ist, und daß die Offsetspannungseinstellung nicht zu einer Verschlechterung des sonstigen Eigenschaften des Komparators, insbesondere nicht zu einer verlangsamten Reaktion auf Veränderungen der Eingangsspannungen führt.

Bezugszeichenliste

| Ix | Strom |
| Iqx | Stromquelle |
| O | Ausgangssignal |

OUT    Ausgangssignal
R      Widerstand
Roff   Widerstand
Sx    Steuereinrichtung
SZx  Schaltungszweig
Tx    Transistor
Vx    Eingangsspannung

**Patentansprüche**

1.  Komparator, welcher ein vom Größenverhältnis einer ersten Spannung (V11) und einer zweiten Spannung (V12) abhängendes Ausgangssignal (OUT) erzeugt, mit einer ersten Steuereinrichtung (S1), einer zweiten Steuereinrichtung (S2), einem Widerstand (Roff), einer ersten Stromquelle (IQ11) und einer zweiten Stromquelle (IQ12),

- wobei die erste Steuereinrichtung (S1) einen ersten Anschluß (A11), einen zweiten Anschluß (A12), und einen dritten Anschluß (A13) aufweist,

  - wobei der erste Anschluß (A11) zur Eingabe der ersten Spannung (V11) dient,
  - wobei der zweite Anschluß (A12) mit dem dritten Anschluß (A13) verbunden ist, und über den Widerstand (Roff) mit einem Anschluß der zweiten Steuereinrichtung (S2) verbunden ist, und
  - wobei der dritte Anschluß (A13) mit der ersten Stromquelle (IQ11) verbunden ist, und über den dritten Anschluß (A13) ein Strom (I1) fließt, dessen Größe von der Differenz der an den ersten Anschluß (A11) und an den zweiten Anschluß (A12) angelegten Spannungen abhängt, und

- wobei die zweite Steuereinrichtung (S2) einen ersten Anschluß (A21), einen zweiten Anschluß (A22), einen dritten Anschluß (A23) und einen vierten Anschluß (A24) aufweist,

  - wobei der erste Anschluß (A21) zur Eingabe der zweiten Spannung (V12) dient,
  - wobei der zweite Anschluß (A22) mit dem vierten Anschluß (A24) verbunden ist, und über den Widerstand (Roff) mit dem zweiten Anschluß (A12) der ersten Steuereinrichtung (S1) verbunden ist,
  - wobei der dritte Anschluß (A23) mit der zweiten Stromquelle (IQ12) verbunden ist, und über den dritten Anschluß (A23) ein Strom (I7) fließt, dessen Größe von der Differenz der an den ersten Anschluß (A21) und an den zweiten Anschluß (A22) angelegten Spannungen abhängt, und am dritten Anschluß (A23) das Ausgangssignal (OUT) der Komparators abgegriffen wird, und
  - wobei der vierte Anschluß (A24) mit dem zweiten Anschluß (A22) verbunden ist, und über den vierten Anschluß (A24) ein Strom (I8) fließt, dessen Größe von der Differenz der an den ersten Anschluß (A21) und an den zweiten Anschluß (A22) angelegten Spannungen abhängt.

2.  Komparator nach Anspruch 1,
**dadurch gekennzeichnet,**
**daß** die Steuereinrichtungen (S1, S2) und die Stromquellen (IQ11, IQ12) so aufgebaut und dimensioniert sind, daß die Differenz zwischen den an den ersten Anschluß (A11) und an den zweiten Anschluß (A12) der ersten Steuereinrichtung (S1) angelegten Spannungen und die Differenz zwischen den an den ersten Anschluß (A21) und an den zweiten Anschluß (A22) der zweiten Steuereinrichtung (S2) angelegten Spannungen gleich groß sind.

3.  Komparator nach Anspruch 1 oder 2,
**dadurch gekennzeichnet,**
**daß** die Steuereinrichtungen (S1, S2) und die Stromquellen (IQ11, IQ12) so aufgebaut und dimensioniert sind, daß der über den vierten Anschluß (A24) der zweiten Steuereinrichtung (S2) fließende Strom (I8) von dem von der ersten Stromquelle (IQ11) abgegebenen Strom (I4) und/oder von dem von der zweiten Stromquelle (IQ12) abgegebenen Strom (I6) abhängt.

4.  Komparator nach Anspruch 3,
**dadurch gekennzeichnet,**
**daß** die Steuereinrichtungen (S1, S2) und die Stromquellen (IQ11, IQ12) so aufgebaut und dimensioniert sind, daß der über den vierten Anschluß (A24) der zweiten Steuereinrichtung (S2) fließende Strom (I8) und der von der zweiten Stromquelle (IQ12) abgegebene Strom (I6) gleich groß sind.

5. Komparator nach einem der vorhergehenden Ansprüche,
**dadurch gekennzeichnet,**
**daß** der vierte Anschluß (A24) der zweiten Steuereinrichtung (S2) mit einer dritten Stromquelle (IQ13) verbunden ist.

6. Komparator nach Anspruch 5,
**dadurch gekennzeichnet,**
**daß** die dritte Stromquelle (IQ13) so aufgebaut und angeordnet ist, daß der über den Widerstand (Roff) fließende Strom (I3) dann, wenn die dritte Stromquelle (IQ13) vorgesehen ist, um den von der dritten Stromquelle (IQ13) abgegebenen Strom (I5) kleiner ist als es der Fall ist, wenn die dritte Stromquelle (IQ13) nicht vorgesehen ist.

7. Komparator nach einem der vorhergehenden Ansprüche,
**dadurch gekennzeichnet,**
**daß** die Größe des Widerstandes (Roff) und/oder die Größe der Ströme (I4, I5, I6) der Stromquellen (IQ11, IQ12, IQ13), von deren Dimensionierung der über den Widerstand (Roff) fließende Strom (I3) abhängt, während des Betriebes des Komparators veränderbar sind.

8. Komparator nach Anspruch 7,
**dadurch gekennzeichnet,**
**daß** die Veränderung unter Verwendung von von außerhalb des Komparators steuerbaren Schaltern oder Steuerelementen erfolgt.

9. Komparator nach einem der vorhergehenden Ansprüche,
**dadurch gekennzeichnet,**
**daß** die erste Steuereinrichtung (S1) durch einen ersten Transistor (T11) gebildet wird, dessen Emitter- bzw. Source-Anschluß den ersten Anschluß (A11) der ersten Steuereinrichtung (S1) bildet, dessen Basis- bzw. Gate-Anschluß den zweiten Anschluß (A12) der ersten Steuereinrichtung (S1) bildet, und dessen Kollektor- bzw. Drain-Anschluß den dritten Anschluß (A13) der ersten Steuereinrichtung (S1) bildet.

10. Komparator nach einem der vorhergehenden Ansprüche,
**dadurch gekennzeichnet,**
**daß** die zweite Steuereinrichtung (S2) durch einen zweiten Transistor (T12) und einen dritten Transistor (T13) gebildet wird, deren Emitter- bzw. Source-Anschlüsse sowie deren Basis- bzw. Gate-Anschlüsse miteinander verbunden sind, und von welchen der gemeinsame Emitter- bzw. Source-Anschluß den ersten Anschluß (A21) der zweiten Steuereinrichtung (S2) bildet, der gemeinsame Basis- bzw. Gate-Anschluß den zweiten Anschluß (A22) der zweiten Steuereinrichtung (S2) bildet, der Kollektor- bzw. Drain-Anschluß des zweiten Transistors (T12) den dritten Anschluß (A23) der zweiten Steuereinrichtung (S2) bildet, und der Kollektor- bzw. Drain-Anschluß des dritten Transistors (T13) den vierten Anschluß (A24) der zweiten Steuereinrichtung (S2) bildet.

11. Komparator nach Anspruch 9 und 10,
**dadurch gekennzeichnet,**
**daß** die Transistoren (T11, T12, T13) und die Stromquellen (IQ11, IQ12, IQ13) so dimensioniert sind, daß sich im Gleichgewichtszustand des Komparators an den Transistoren (T11, T12, T13) die selbe Basis-Emitter-Spannung bzw. die selbe Gate-Source-Spannung einstellt.

12. Komparator nach Anspruch 9 und 10,
**dadurch gekennzeichnet,**
**daß** die Transistoren (T11, T12, T13) und die Stromquellen (IQ11, IQ12, IQ13) so dimensioniert sind, daß die im Gleichgewichtszustand des Komparators durch die Transistoren (T11, T12, T13) fließenden Ströme gleich groß sind.

13. Komparator nach einem der vorhergehenden Ansprüche,
**dadurch gekennzeichnet,**
**daß** die Stromquellen (IQ11, IQ12, IQ13) so dimensioniert sind, daß dann, wenn keine dritte Stromquelle (IQ13) vorgesehen ist, der von der ersten Stromquelle (IQ11) abgegebene Strom doppelt (I4) so groß ist wie der von der zweiten Stromquelle (IQ12) abgegebene Strom (I6).

14. Komparator nach einem der vorhergehenden Ansprüche,

**dadurch gekennzeichnet,**
**daß** die Stromquellen (IQ11, IQ12, IQ13) so dimensioniert sind, daß dann, wenn eine dritte Stromquelle (IQ13) vorgesehen ist, der von der ersten Stromquelle (IQ11) abgegebene Strom (I4) um den von der dritten Stromquelle (IQ13) abgegebenen Strom (I5) kleiner ist als das Doppelte des von der zweiten Stromquelle (IQ12) abgegebenen Stroms (I6).

**Claims**

1. Comparator which generates an output signal (OUT) which is dependent on the size ratio of a first voltage (V11) and a second voltage (V12), having a first control device (S1), a second control device (S2), a resistor (Roff), a first power source (IQ11) and a second power source (IQ12),

   - the first control device (S1) having a first terminal (A11), a second terminal (A12), and a third terminal (A13),

       - the first terminal (A11) being used to input the first voltage (V11),
       - the second terminal (A12) being connected to the third terminal (A13), and via the resistor (Roff) to the terminal of the second control device (S2), and
       - the third terminal (A13) being connected to the first power source (IQ11), and a current (I1) whose size depends on the difference between the voltages applied to the first terminal (A11) and to the second terminal (A12) flowing via the third terminal (A13), and

   - the second control device (S2) having a first terminal (A21), a second terminal (A22), a third terminal (A23) and a fourth terminal (A24),

       - the first terminal (A21) being used to input the second voltage (V12),
       - the second terminal (A22) being connected to the fourth terminal (A24), and via the resistor (Roff) to the second terminal (A12) of the first control device (S1),
       - the third terminal (A23) being connected to the second power source (IQ12), and a current (I7) whose size depends on the difference between the voltages applied to the first terminal (A21) and to the second terminal (A22) flowing via the third terminal (A23), and the output signal (OUT) of the comparator being tapped at the third terminal (A23), and
       - the fourth terminal (A24) being connected to the second terminal (A22), and a current (I8) whose size depends on the difference between the voltages applied to the first terminal (A21) and to the second terminal (A22) flowing via the fourth terminal (A24).

2. Comparator according to Claim 1, **characterized in that** the control devices (S1, S2) and the power sources (IQ11, IQ12) are constructed and dimensioned in such a way that the difference between the voltages applied to the first terminal (A11) and to the second terminal (A12) of the first control device (S1) and the difference between the voltages applied to the first terminal (A21) and to the second terminal (A22) of the second control device (S2) are equally large.

3. Comparator according to Claim 1 or 2, **characterized in that** the control devices (S1, S2) and the power sources (IQ11, IQ12) are constructed and dimensioned in such a way that the current (I8) flowing via the fourth terminal (A24) of the second control device (S2) depends on the current (I4) which is output by the first power source (IQ11) and/or on the current (I6) which is output by the second power source (IQ12).

4. Comparator according to Claim 3, **characterized in that** the control devices (S1, S2) and the power sources (IQ11, IQ12) are constructed and dimensioned in such a way that the current (I8) which flows via the fourth terminal (A24) of the second control device (S2) and the current (I6) which is output by the second power source (IQ12) are equally large.

5. Comparator according to one of the preceding claims, **characterized in that** the fourth terminal (A24) of the second control device (S2) is connected to a third power source (IQ13).

6. Comparator according to Claim 5, **characterized in that** the third power source (IQ13) is constructed and arranged in such a way that, when the third power source (IQ13) is provided, the current (I3) flowing via the resistor (Roff) is smaller, by an amount equal to the current (I5) which is output by the third power source (IQ13), than is the case when the second power source (IQ13) is not provided.

7. Comparator according to one of the preceding claims, **characterized in that** the size of the resistor (Roff) and/or the size of the currents (I4, I5, I6) of the power sources (IQ11, IQ12, IQ13), on whose dimensioning the current (I3) flowing via the resistor (Roff) depends, are variable during the operation of the comparator.

8. Comparator according to Claim 7, **characterized in that** the change is carried out using switches or control elements which can be controlled from outside the comparator.

9. Comparator according to one of the preceding claims, **characterized in that** the first control device (S1) is formed by a first transistor (T11) whose emitter and source terminal forms the first terminal (A11) of the first control device (S1), whose base and gate terminal forms the second terminal (A12) of the first control device (S1), and whose collector and drain terminal forms the third terminal (A13) of the first control device (S1).

10. Comparator according to one of the preceding claims, **characterized in that** the second control device (S2) is formed by a second transistor (T12) and a third transistor (T13), whose emitter and source terminals and whose base and gate terminals are connected to one another, and of which the common emitter and source terminal forms the first terminal (A21) of the second control device (S2), the common base and gate terminal forms the second terminal (A22) of the second control device (S2), the collector and drain terminal of the second transistor (T12) forms the third terminal (A23) of the second control device (S2), and the collector and drain terminal of the third transistor (T13) forms the fourth terminal (A24) of the second control device (S2).

11. Comparator according to Claims 9 and 10, **characterized in that** the transistors (T11, T12, T13) and the power sources (IQ11, IQ12, IQ13) are dimensioned in such a way that, in the state of equilibrium of the comparator, the same base-emitter voltage or the same gate-source voltage is set at the transistors (T11, T12, T13).

12. Comparator according to Claims 9 and 10, **characterized in that** the transistors (T11, T12, T13) and the power sources (IQ11, IQ12, IQ13) are dimensioned in such a way that the currents flowing through the transistors (T11, T12, T13) in the state of equilibrium of the comparator are equally large.

13. Comparator according to one of the preceding claims, **characterized in that** the power sources (IQ11, IQ12, IQ13) are dimensioned in such a way that, when no third power source (IQ13) is provided, the current (I4) which is output by the first power source (IQ11) is twice as large as the current (I6) which is output by the second power source (IQ12).

14. Comparator according to one of the preceding claims, **characterized in that** the power sources (IQ11, IQ12, IQ13) are dimensioned in such a way that, when a third power source (IQ13) is provided, the current (I4) which is output by the first power source (IQ11) is smaller, by an amount equal to the current (I5) which is output by the third power source (IQ13), than twice the current (I6) which is output by the second power source (IQ12).

**Revendications**

1. Comparateur, générant un signal de sortie (OUT) dépendant du rapport de grandeurs entre une première tension (V11) et une seconde tension (V12), avec un premier dispositif de commande (S1), un second dispositif de commande (S2), une résistance (Roff), une première source de courant (IQ11) et une seconde source de courant (IQ12),

- le premier dispositif de commande (S1) présentant un premier branchement (A11), un second branchement (A12) et un troisième branchement (A13),

  - le premier branchement (A11) étant destiné à l'introduction de la première tension (V11),

  - le second branchement (A12) étant relié au troisième branchement (A13) et étant relié à un branchement du second dispositif de commande (S2), par l'intermédiaire de la résistance (Roff),

  - le troisième branchement (A13) étant relié à la première source de courant (IQ11) et un courant (I1) dont la valeur dépend de la différence entre la tension appliquée sur le premier branchement (A11) et la tension appliquée sur le second branchement (A12) s'écoulant à travers le troisième branchement (A13), et

- le second dispositif de commande (S2) présentant un premier branchement (A21), un second branchement (A22), un troisième branchement (A23) et un quatrième branchement (A24),

    - le premier branchement (A21) étant destiné à l'introduction de la seconde tension (V12),

    - le second branchement (A22) étant relié au quatrième branchement (A24) et étant relié au second branchement (A12) du premier dispositif de commande (S1), par l'intermédiaire de la résistance (Roff),

    - le troisième branchement (A23) étant relié à la seconde source de courant (IQ12) et un courant (I7) dont la valeur dépend de la différence entre la tension appliquée sur le premier branchement (A21) et la tension appliquée sur le second branchement (A22) s'écoulant à travers le troisième branchement (A23) et le signal de sortie (OUT) du comparateur étant recueilli sur le troisième branchement (A23) et

    - le quatrième branchement (A24) étant relié au second branchement (A22) et un courant (I8) dont la valeur dépend de la différence entre la tension appliquée sur le premier branchement (A21) et la tension appliquée sur le second branchement (A22) s'écoulant à travers le quatrième branchement (A24).

2. Comparateur selon la revendication 1, **caractérisé en ce que** les dispositifs de commande (S1, S2) et les sources de courant (IQ11, IQ12) sont conçus et dimensionnés de façon telle que la différence entre les tensions appliquées sur le premier branchement (A11) et sur le second branchement (A12) du premier dispositif de commande (S1) et la différence entre les tensions appliquées sur le premier branchement (A21) et sur le second branchement (A22) du second dispositif de commande (S2) soient de valeur égale.

3. Comparateur selon l'une quelconque des revendications 1 ou 2, **caractérisé en ce que** les dispositifs de commande (S1, S2) et les sources de courant (IQ11, IQ12) sont conçus et dimensionnés de façon telle que le courant (I8) circulant à travers le quatrième branchement (A24) du second dispositif de commande (S2) dépende du courant (I4) restitué par la première source de courant (IQ11) et/ou du courant (I6) restitué par la seconde source de courant (IQ12).

4. Comparateur selon la revendication 3, **caractérisé en ce que** les dispositifs de commande (S1, S2) et les sources de courant (IQ11, IQ12) sont conçus et dimensionnés de façon telle que le courant (I8) circulant à travers le quatrième branchement (A24) du second dispositif de commande (S2) et le courant (I6) restitué par la seconde source de courant (IQ12) soient de valeur égale.

5. Comparateur selon l'une quelconque des revendications précédentes, **caractérisé en ce que** le quatrième branchement (A24) du second dispositif de commande (S2) est relié à une troisième source de courant (IQ13).

6. Comparateur selon la revendication 5, **caractérisé en ce que** la troisième source de courant (IQ13) est conçue et disposée de façon à ce que le courant (I3) circulant à travers la résistance (Roff), si la troisième source de courant (IQ13) est prévue, soit inférieur de la valeur du courant (I5) restitué par la troisième source de courant (IQ13) par rapport au cas où la troisième source de courant (IQ13) n'est pas prévue.

7. Comparateur selon l'une quelconque des revendications précédentes, **caractérisé en ce que** la valeur de la résistance (Roff) et/ou la valeur des courants (I4, I5, I6) des sources de courant (IQ11, IQ12, IQ13), du dimensionnement desquelles dépend le courant (I3) circulant à travers la résistance (Roff), est modifiable en cours de fonctionnement du comparateur.

8. Comparateur selon la revendication 7, **caractérisé en ce que** la modification a lieu par utilisation de commutateurs ou d'éléments de commande pilotables à partir de l'extérieur du comparateur.

9. Comparateur selon l'une quelconque des revendications précédentes, **caractérisé en ce que** le premier dispositif de commande (S1) est formé par un premier transistor (T11), dont le branchement de l'émetteur ou de la source forme le premier branchement (A11) du premier dispositif de commande (S1), dont le branchement de base ou le branchement de grille forme le second branchement (A12) du premier dispositif de commande (S1) et dont le branchement du collecteur ou le branchement du drain forme le troisième branchement (A13) du premier dispositif de commande (S1).

**10.** Comparateur selon l'une quelconque des revendications précédentes, **caractérisé en ce que** le second dispositif de commande (S2) est formé par un second transistor (T12) et par un troisième transistor (T13), dont les branchements de l'émetteur ou de la source, ainsi que les branchements de la base ou de la grille sont reliés entre eux et dont le branchement commun de l'émetteur ou de la source forme le premier branchement (A21) du second dispositif de commande (S2), dont le branchement commun de la base ou de la grille forme le second branchement (A22) du second dispositif de commande (S2), dont le branchement du collecteur ou du drain du second transistor (T12) forme le troisième branchement (A23) du second dispositif de commande (S2) et dont le branchement du collecteur ou du drain du troisième transistor (T13) forme le quatrième branchement (A24) du second dispositif de commande (S2).

**11.** Comparateur selon l'une quelconque des revendications 9 et 10, **caractérisé en ce que** les transistors (T11, T12, T13) et les sources de courant (IQ11, IQ12, IQ13) sont dimensionnés de façon à ce qu'à l'état d'équilibre du comparateur, la même tension base-émetteur ou la même tension grille-source se règle sur les transistors (T11, T12, T13).

**12.** Comparateur selon l'une quelconque des revendications 9 ou 10, **caractérisé en ce que** les transistors (T11, T12, T13) et les sources de courant (IQ11, IQ12, IQ13) sont dimensionnés de façon à ce qu'à l'état d'équilibre du comparateur, les courants circulant à travers les transistors (T11, T12, T13) soient de valeur égale.

**13.** Comparateur selon l'une quelconque des revendications précédentes, **caractérisé en ce que** les sources de courant (IQ11, IQ12, IQ13) sont dimensionnées de façon telle que lorsqu'aucune troisième source de courant (IQ13) n'est prévue, le courant (I4) restitué par la première source de courant (IQ11) corresponde au double de la valeur du courant (I6) restitué par la seconde source de courant (IQ12).

**14.** Comparateur selon l'une quelconque des revendications précédentes, **caractérisé en ce que** les sources de courant (IQ11, IQ12, IQ13) sont dimensionnées de façon telle que lorsqu'une troisième source de courant (IQ13) est prévue, le courant (I4) restitué par la première source de courant (IQ11) soit inférieur de la valeur du courant (I5) restitué par la troisième source de courant (IQ13) par rapport au double de la valeur du courant (I6) restitué par la seconde source de courant (IQ12).

**FIG 1**

**FIG 2**

**FIG 3**

**FIG 4**